# EUROPEAN PATENT APPLICATION

(11) **EP 0 818 556 A1**
(43) Date of publication of application: **14.01.1998**
(21) Application number: 97110647.1
(22) Date of filing: 30.06.1997
(51) Int. Cl.: C23C 14/34, C23C 14/18, C23C 14/06

(54) **A method for providing full-face high density plasma deposition**

(30) Priority: 09.07.1996 US 677588
(71) Applicant: Applied Materials, Inc., Santa Clara, CA 95054 (US)
(72) Inventor: Ngan, Kenny King-Tai, Fremont, California 94539 (US); Hui, Simon, Fremont, California 94555 (US); Yao, Gongda, Fremont, California 94539 (US)
(74) Representative: Kahler, Kurt, Dipl.-Ing.

(57) **Abstract**

A material deposition system (100) which ionizes deposition material in a plasma and accelerates the ionized deposition material onto a deposition substrate (112) without the necessity for externally biasing the substrate (112). In addition, the need for supplying a backflow of gas to the back side of the deposition substrate (112) for the purpose of controlling the temperature of the substrate has also been eliminated. In the illustrated embodiment, the substrate (112) is supported on a pedestal (114) which does not engage or clamp the front deposition face of the substrate (112). As a consequence, no portion of the front surface of the substrate (112) is covered by a clamping mechanism such that the entire surface of the front face of the substrate (112) may be deposited with deposition material. Still further, crystallographic properties of ionized deposited material may be improved by permitting the substrate (112) to self-generate a bias.

## Description

### FIELD OF THE INVENTION

The present invention relates to sputter deposition, and more particularly, to a method and apparatus for sputter depositing a layer of material in the fabrication of semiconductor devices.

### BACKGROUND OF THE INVENTION

Low pressure radio frequency (RF) generated plasmas have become convenient sources of energetic ions and activated atoms which can be employed in a variety of semiconductor device fabrication processes including surface treatments, depositions, and etching processes. For example, to deposit materials onto a semiconductor wafer using a sputter deposition process, a plasma is produced in the vicinity of a sputter target material which is negatively biased. Ions created within the plasma impact the surface of the target to dislodge, i.e., "sputter" material from the target. The sputtered materials are then transported and deposited on the surface of the semiconductor wafer.

Sputtered material has a tendency to travel in straight line paths from the target to the substrate being deposited at angles which are oblique to the surface of the substrate. As a consequence, materials deposited in etched trenches and holes of semiconductor devices having trenches or holes with a high depth to width aspect ratio, can bridge over causing undesirable voids or cavities in the deposition layer. To prevent such cavities, the sputtered material can be directed into substantially vertical paths between the target and the substrate by negatively charging the substrate to position appropriate vertically oriented electric fields adjacent the substrate if the sputtered material is sufficiently ionized by the plasma. However, material sputtered by a low density plasma often has an ionization degree of less than 1% which is usually insufficient to avoid the formation of an excessive number of cavities. Accordingly, it is desirable to increase the density of the plasma to increase the ionization rate of the sputtered material to a level greater than 1% of the sputtered material in order to decrease the formation degree of unwanted voids in the deposition layer. As used herein, the term "dense plasma" is intended to refer to one that has a high electron and ion density.

There are several known techniques for exciting a plasma with RF fields including capacitive coupling, inductive coupling and wave heating. In a standard inductively coupled plasma (ICP) generator, RF current passing through a coil surrounding the plasma induces electromagnetic currents in the plasma. These currents heat the conducting plasma by ohmic heating, so that it is sustained in steady state. As shown in U.S. Pat. No. 4,362,632, for example, current through a coil is supplied by an RF generator coupled to the coil through an impedance matching network, such that the coil acts as the first windings of a transformer. The plasma acts as a single turn second winding of a transformer.

To bias the substrate, it is important to make good electrical contact to the substrate. This is typically achieved by clamping the substrate using a conductive metal clamp ring which surrounds and engages the outer periphery of the substrate. Such a clamp ring also holds the substrate in place. A backflow of gas applied to the underside of the substrate for purposes of temperature control can dislodge the substrate if the substrate is not firmly clamped in position. However, because the clamp ring typically covers the outer portion of the substrate face, full face coverage by the deposition metal has typically not been achieved in inductively coupled radio frequency (RFI) high density plasma sputtering devices. As a consequence, valuable area of the wafer can be wasted.

### SUMMARY OF THE PREFERRED EMBODIMENTS

It is an object of the present invention to provide an improved method and apparatus for depositing ionized deposition materials, particularly in a manner requiring a relatively uncomplicated electrical and mechanical arrangement.

These and other objects and advantages are achieved in a material deposition system which ionizes deposition material in a plasma and accelerates the ionized deposition material onto a deposition substrate without the necessity for externally biasing the substrate. In addition, the need for supplying a backflow of gas to the back side of the deposition substrate for the purpose of controlling the temperature of the substrate has also been eliminated.

In the illustrated embodiment, the substrate is supported on a pedestal which does not engage or clamp the front deposition face of the substrate. As a consequence, no portion of the front surface of the substrate is covered by a clamping mechanism such that the full surface of the front face of the substrate may be deposited with deposition material. In addition, because the need for biasing the substrate has been eliminated, the design of the pedestal may be simplified. Still further, elimination of a backflow of gas to the back side of the substrate permits further simplification of the pedestal for high density plasma ionized deposition material systems.

In accordance with one aspect of the invention, it has been recognized that satisfactory step coverage of high aspect ratio vias and trenches may be achieved in a high density plasma ionized material deposition system without the need for externally biasing the substrate. Instead, it is believed that sufficient electrical fields are generated within the sheath surrounding the plasma to accelerate the ionized deposition material through the sheath adjacent to the substrate to deposit the ionized material onto the substrate in a path substantially normal to the deposition surface. Thus, by utilizing the electric fields generated by the plasma sheath, the need for externally biasing the surface to generate electric fields for the purpose of accelerating the ionized material toward the substrate can be eliminated.

In another aspect of the present invention, it has been recognized that by eliminating external biasing of the substrate, any temperature rise in the substrate as a result of the deposition of ionized material onto the substrate remains within acceptable limits even if the backflow of gas to the backside of the substrate for purposes of temperature control is eliminated. By avoiding both external biasing of the substrate and back flow temperature control of the substrate, clamping of the substrate can be eliminated, thereby permitting full face deposition coverage of the substrate as well as simplification of the pedestal as noted above. In addition, such an arrangement can potentially reduce particles due to elimination of the clamp ring.

In yet another aspect of the present invention, it has been found that the crystallographic properties of the various materials deposited in a high density plasma ionized deposition system may be improved by eliminating biasing of the substrate. For example, a layer of titanium deposited by a high density plasma ionized deposition material system in accordance with the present invention has a crystallographic orientation which is substantially similar to that of titanium deposited by conventional sputtering systems which do not ionize the titanium prior to deposition. More specifically, the titanium layer has a crystallographic orientation which is substantially (002) which is believed to improve the quality of a subsequent layer of metal such as aluminum deposited over the titanium.

In another example, a layer of titanium nitride deposited by a high density plasma ionized material deposition system in accordance with the present invention has a crystallographic orientation which is substantially similar to that of titanium nitride deposited by conventional sputtering systems which do not ionize the titanium nitride prior to deposition. More specifically, the titanium nitride layer has crystallographic orientations which are substantially (200) and (111), respectively. An orientation of (200) in titanium nitride is believed to improve the resistivity and the barrier properties of the titanium nitride. An orientation of (111) is believed to influence an overlying layer of metal such as aluminum to also have an increased (111) orientation which is believed to improve electromigration properties of the aluminum deposited over the titanium nitride.

### BRIEF DESCRIPTION OF THE DRAWINGS

Fig. 1 is a schematic representation of an inductively coupled radio frequency high density plasma ionized material deposition system in accordance with one embodiment of the present invention.

Fig. 2 is a schematic cross-sectional representation of a substrate supporting pedestal of the system of Fig. 1.

Fig. 3 is a schematic representation of the voltage drop and associated ion redirecting electric fields provided by the sheath between the plasma and the substrate of the system of Fig. 1.

Fig. 4 is a table comparing the bottom coverage of vias utilizing an RFI high density plasma deposition onto an externally biased substrate to that of an RFI high density plasma deposition onto a substrate which is not externally biased.

Fig. 5 is a graph illustrating the temperature rise of substrates deposited with various materials in which the substrate is not biased during RFI high density plasma deposition.

Fig. 6 is a graph of x-ray diffraction data depicting the crystallographic orientation of a titanium layer deposited on a substrate without RFI plasma ionization of the titanium prior to deposition.

Fig. 7 is a graph of x-ray diffraction data depicting the crystallographic orientation of two titanium layers deposited on substrates using RFI plasma ionization of the titanium prior to deposition, in which one substrate was externally biased and the other was not.

Fig. 8 is a graph of x-ray diffraction data depicting the crystallographic orientation of a titanium nitride layer deposited on a substrate without RFI plasma ionization of the titanium nitride prior to deposition.

Fig. 9 is a graph of x-ray diffraction data depicting the crystallographic orientation of two titanium nitride layers deposited on substrates using RFI plasma ionization of the titanium nitride prior to deposition, in which one substrate was externally biased and the other was not.

### DETAILED DESCRIPTION OF THE DRAWINGS

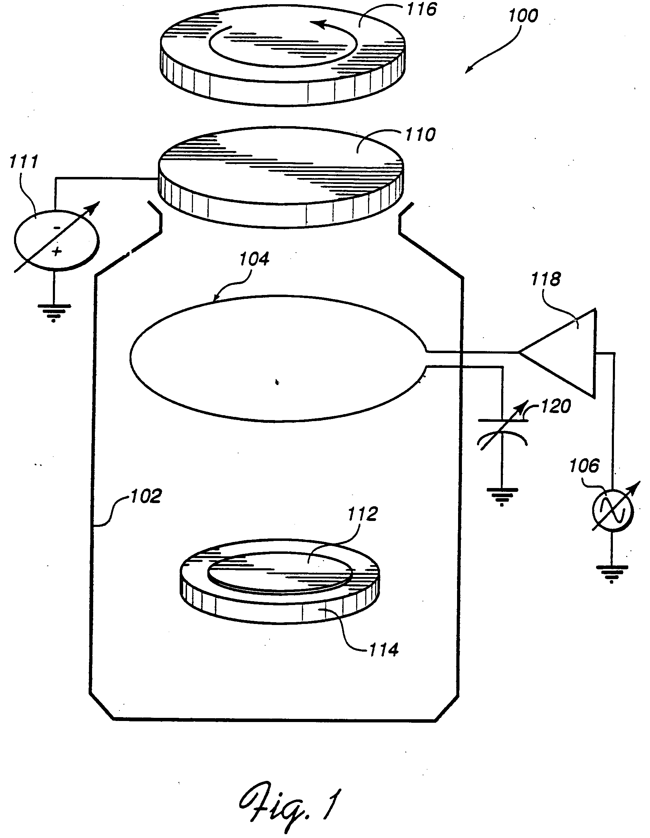

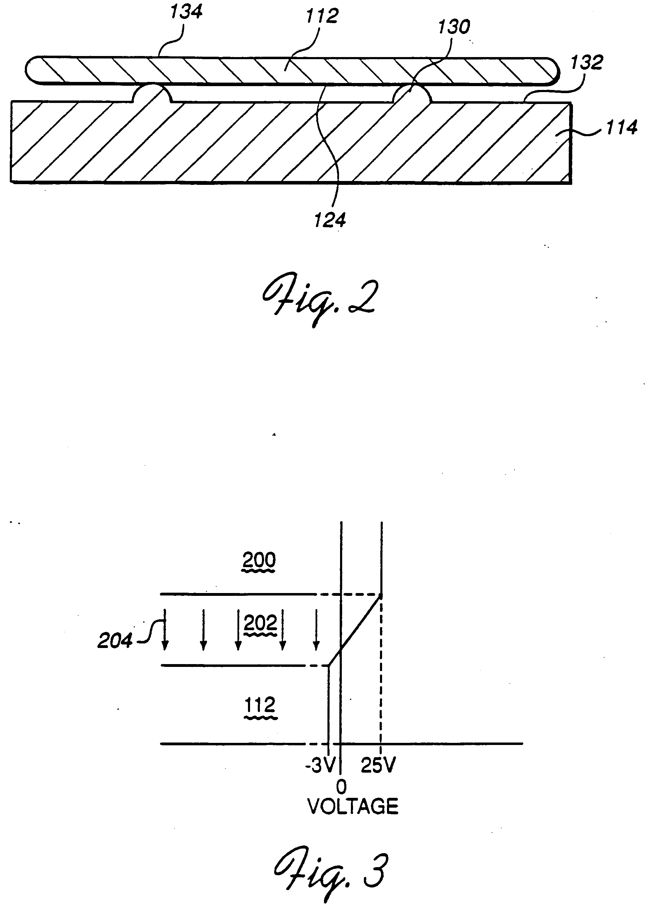

Referring first to Figs. 1 and 2, an RFI high density plasma ionized material deposition system in accordance with a first embodiment of the present invention is schematically represented in Fig. 1. The system 100 includes a vacuum chamber 102 which permits the interior pressure of the chamber 102 to be pumped to a very low level. The deposition system 100 of this embodiment has a single turn coil 104 which is carried internally by a shield (not shown) which protects the interior walls of the vacuum chamber 102 from the material being deposited within the interior of the deposition system 100.

Radio frequency (RF) energy from an RF generator 106 is radiated from the coil 104 into the interior of the deposition system 100, which energizes a plasma within the deposition system 100. The energized plasma produces a plasma ion flux which strikes a negatively biased target 110 positioned at the top of the chamber 102. The target 110 is negatively biased by a DC power source 111. The plasma ions eject material from the target 110 onto a substrate 112 which may be a wafer or other workpiece which is supported by a support member such as a pedestal 114 at the bottom of the deposition system 100. A rotating magnet assembly 116 provided above the target 110 produces magnetic fields which sweep over the face of the target 110 to promote uniform erosion of the target.

Preferably, more than 1% of the atoms of material ejected from the target 110 are in turn ionized by the plasma being energized by the coil 104 which is inductively coupled to the plasma. The RF generator 106 is preferably coupled to the coil 104 through an amplifier and impedance matching network 118. The other end of the coil 104 is coupled to ground, preferably through a capacitor 120 which may be a variable capacitor.

As will be explained in greater detail below, in accordance with one aspect of the present invention, the substrate 112 is preferably not negatively biased by an external source to attract the ionized deposition material to the substrate. Instead, the naturally occurring voltage drop which is believed to appear across the sheath between the plasma and the substrate (located on a grounded or electrically floating support member) is relied upon to produce electric fields to direct the ionized deposition material toward the substrate in a substantially transverse direction to the surface of the substrate. It has been found that very satisfactory step coverage of vias and channels having relatively high aspect ratios may be achieved notwithstanding the absence of an external bias applied to the substrate.

In yet another aspect of the present invention, it has been found that temperature control of the substrate by providing a flow of gas to the backside (or underside) of the substrate 112 can be avoided without substantial adverse effect on the deposition layer or underlying structures. As a consequence, as explained in greater detail below, the construction of the pedestal in inductively coupled high density plasma ionized material deposition systems may be significantly simplified. In addition, full face coverage of the substrate may be readily achieved.

Fig. 2 is a schematic cross-sectional representation of the pedestal 114 which is preferably electrically insulated from any grounded or externally biased structures of the chamber so that the potential of the pedestal is allowed to float. Because the substrate 112 is also not externally biased, the need to provide good electrical contact to the substrate is eliminated. Consequently, clamp rings and other devices for making electrical contact to the substrate can be eliminated, thereby substantially simplifying the design of the pedestal 114 for RFI high density plasma ionized material deposition systems, as depicted in Fig. 2. It should further be noted that the pedestal 114 can lack backflow gas channels passing through the pedestal to the underside 124 of the substrate 112, permitting further simplification of the pedestal 114. However, channels may be provided (not shown) to permit passage of pick up pins to lift the substrate 112 off the pedestal 114 following processing to facilitate pick up by a robot hand (not shown).

To reduce electrical and thermal coupling between the pedestal 114 and the substrate 112, it may be desirable in some applications to provide hemispherically shaped dimples such as those indicated at 130 in Fig. 2, to support the substrate spaced a predetermined distance from the primary upper surface 132 of the pedestal. In the illustrated embodiment, the dimples 130 have a height of approximately 0.125 inches to support an 8 inch diameter wafer, although a height of 2-6 millimeters would also be satisfactory. Although the support member 114 is described as a pedestal, the support member may be any of a variety of structures which can support a substrate including chucks and support tables.

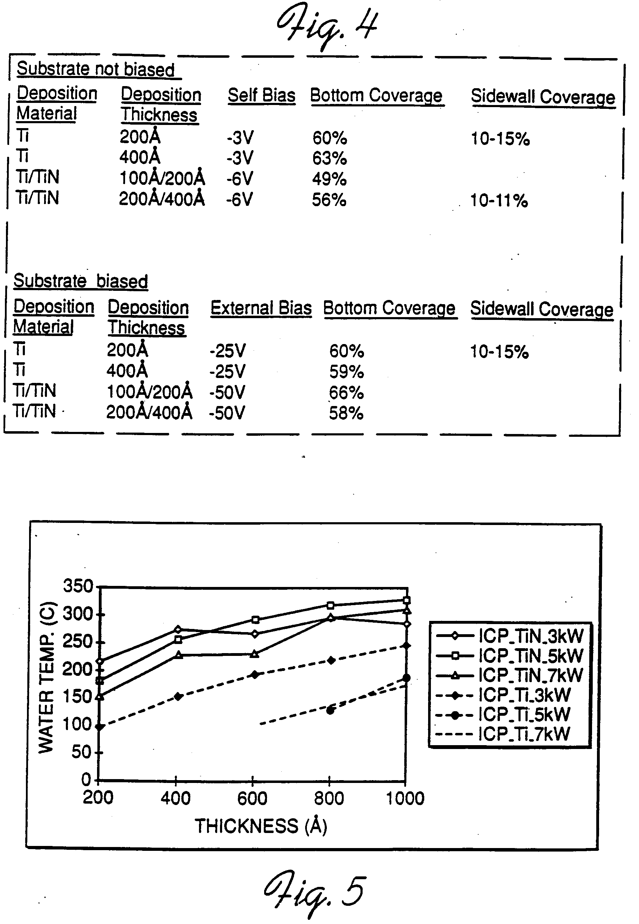

Referring now to Fig. 3, a portion of the energized plasma is represented schematically as indicated generally at 200. Although it is difficult to accurately measure the potential of the plasma 200, it is believed by the present inventors that the potential of the plasma 200 in a typical RFI high density plasma in semiconductor fabrication chambers is approximately 25 volts. At the edge of the plasma is an outer region 202 which is usually referred to as the "sheath." Because the plasma typically exhibits a positive potential, the sheath 202 typically exhibits a potential drop across the sheath region as indicated in Fig. 3, particularly adjacent those portions of the chamber which are grounded. If the substrate 112 is not externally biased or grounded, it has been found that substrate can self bias to a level of approximately -3 volts. Hence, the voltage drop from the plasma 200, across the sheath 202 to the substrate 112 can be on the order of 30 or more volts. This voltage drop has associated therewith electric fields which are believed to be oriented substantially perpendicular to the surface of the substrate 112 as represented by the field lines 204 in Fig. 3. These electric fields are generated "naturally" by the sheath 202 without the need of any external biasing of the substrate 112.

In accordance with one aspect of the present invention, it has been found that these electric fields naturally occurring in the sheath adjacent to the substrate are sufficiently strong and of the proper orientation to redirect the ionized deposition material to achieve highly satisfactory step coverage of vias and other vertical structures, even those having relatively high aspect ratios. Fig. 4 is a table comparing the results of several RFI high density plasma ionized depositions of various materials onto substrates which were not externally biased to the results of similar RFI sputtered depositions except that the substrates were externally biased. As shown in Fig. 4, the resultant bottom coverage over 0.5 micron vias having a 3:1 aspect ratio was substantially the same whether or not the substrate was externally biased. As a consequence, it has been found that external biasing of the substrate during RFI high density plasma sputtering can be eliminated, thereby eliminating for many applications the need for clamping the substrate to apply an external bias thereto. As a result, full face coverage of the entire upper surface 134 of the substrate 112 (Fig. 2) by the deposition material can be readily achieved, even for deposition substrates having high aspect ratio vias and channels. Although it is preferred that the pedestal 114 be electrically insulated, and that the substrate 112 be electrically free floating, it is anticipated that in some applications the pedestal 114 or the substrate 112 could be grounded or a small bias applied and yet achieve many of the advantages of the illustrated embodiment.

In accordance with another aspect of the present invention, it has been found that back flow of gas to the underside of the substrate can be eliminated for many RFI high density plasma sputtered depositions, particularly where the substrate is not externally biased. The back flow of gas such as argon to the underside of a substrate during deposition is a common technique for controlling the temperature of the substrate. Another function of clamp rings in addition to applying a bias to the substrate, is to secure the substrate in place to prevent the flow of gas from dislodging the substrate during the deposition. As the ionized material bombards the substrate, the temperature of the substrate tends to rise. In RFI high density plasma depositions in which the surface is externally biased through the clamp ring, a back flow of argon gas may be utilized to compensate for this temperature rise by supplying a heat transfer path from the substrate to the support.

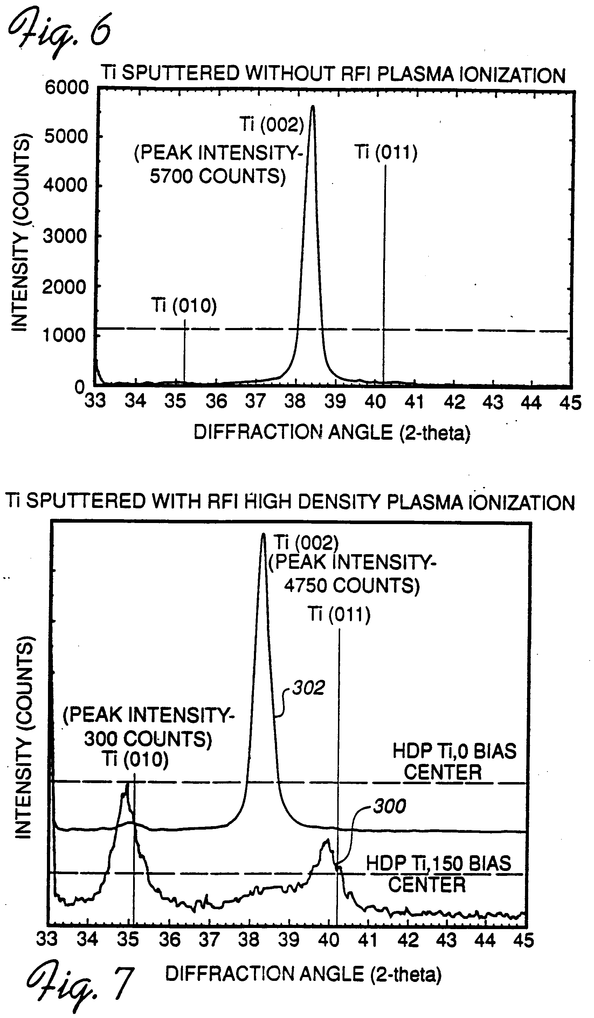

Fig. 5 shows the temperatures of several wafers at various times as materials were deposited on the wafers without biasing the wafers, and without clamping the wafers in place or applying a back flow of gas to the underside of the substrate. The temperatures of the wafers were measured by a non-contact measurement technique. As shown in Fig. 5, the wafer temperature during a deposition of titanium nitride increased from 180°C to 328°C as the deposition thickness increased from 200Å to 1,000Å. Such a temperature rise is within acceptable limits. It is believed in some applications that the temperature of the wafer should not rise above 340-400°C during deposition to avoid adversely affecting the resultant device. Furthermore, many applications require a deposition of only 600Å rather than 1,000Å. For such applications, the temperature will rise to a level substantially below 340°C as shown in Fig. 5. The wafer temperature following the deposition of 1000Å of titanium was even lower, below 250°C.

As shown in Fig. 5, the wafer temperature remained below 350°C following the deposition of 1000Å of TiN and below 250°C for 1,000Å of Ti, notwithstanding varying the DC power to the target from 3 to 7 kw as the RF power to the coil was maintained at 1.5 kw. Hence, the process window for acceptable wafer temperatures appears to be relatively wide if external biasing of the substrate is avoided even when the back flow of argon gas is eliminated. Thus, if the backflow of gas for temperature control is eliminated, the clamping of the substrate for the purpose of securing the substrate in place during backflow temperature control can likewise be eliminated. As a consequence, full face coverage of the deposition metal over the vias and channels can be achieved by the elimination of clamping of the substrate.

In addition to blocking the region of the wafer adjacent to its edge from deposition material, clamping the wafer has another disadvantage. In many semiconductor fabrication processes, a layer of tungsten is often deposited by chemical vapor deposition over an underlying layer of titanium nitride. Chemical vapor deposition typically does not require the substrate to be clamped. Hence, if the substrate is clamped for the titanium nitride deposition but not for the subsequent tungsten deposition, tungsten will often be deposited on a ring of oxide left exposed by the clamp ring which prevented full face coverage by the titanium nitride deposition. Tungsten typically does not adhere to oxide as well as it does to titanium nitride. Hence, the tungsten can flake off from the ring of oxide which was not covered by the prior deposition, thereby causing particles which can contaminate the wafer. However, if the titanium nitride or other underlying metal layer is deposited by an RFI high density plasma deposition in accordance with the present invention in which the substrate is not clamped, full face coverage of the substrate can be achieved thereby increasing the utilization of the wafer and decreasing the generation of particulates because the tungsten can bind to an underlying layer of titanium nitride over the entire face of the substrate including the edge.

In accordance with yet another aspect of the present invention, it has been found that the crystallographic properties of various materials deposited by RFI high density plasma ionized deposition can be substantially improved by permitting the substrate to self bias rather than applying an external bias during the deposition. More specifically, it is believed that the crystallographic orientation of titanium when deposited on a self biased substrate during RFI high density plasma ionized deposition exhibits a crystallographic orientation which is substantially (002) oriented. It is further believed that aluminum when deposited over an underlying titanium layer which is (002) oriented has an improved quality.

Fig. 6 indicates the crystallographic orientation of a titanium film deposited in a conventional physical vapor deposition chamber which does not utilize a coil to inductively couple RF energy into the plasma to ionize the deposition material from the target. As shown in Fig. 6, x-ray diffraction of the film produced in this manner indicates that the titanium film is primarily oriented in the (002) crystallographic orientation. As noted above, it is believed that such a crystallographic orientation in the titanium film promotes good qualities in an aluminum film subsequently deposited over the titanium.

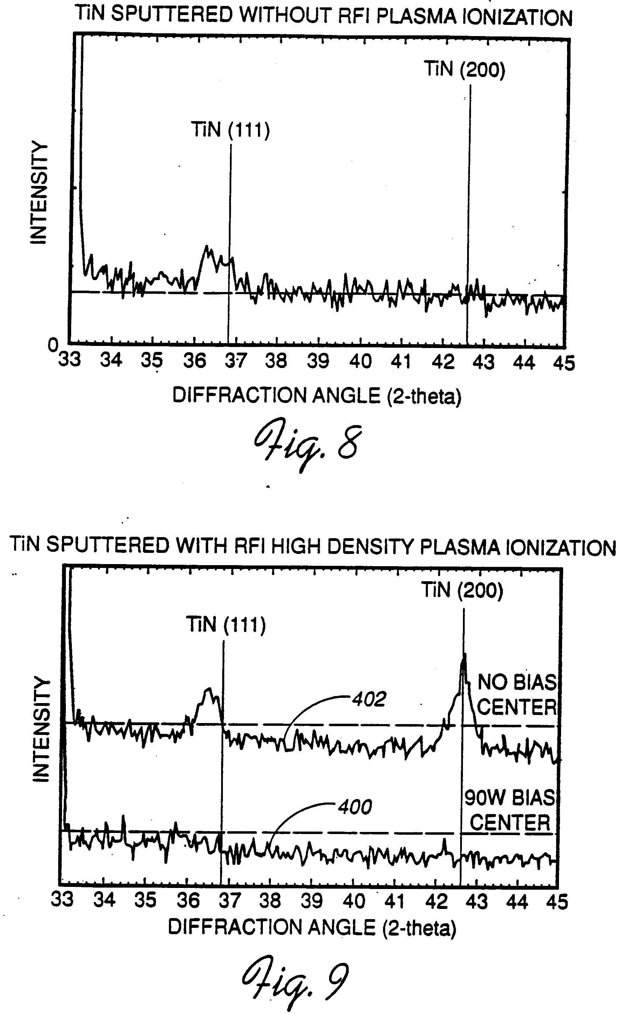

By comparison, Fig. 7 indicates the crystallographic orientations of two titanium films, both deposited in an RFI high density plasma deposition chamber. However, one titanium film as represented by the data line 300, was deposited on a substrate which was externally biased via a clamp ring applied to the substrate to a voltage of approximately -30 volts at a power of 150 watts. The other titanium film as represented by the data line 302, was deposited in accordance with the present invention in an RFI chamber but with no external bias to the substrate. Instead, the substrate which was clamped by a clamp ring and supported by a pedestal at a floating potential. As a consequence, the substrate self generated a DC bias which was measured to be approximately -3 volts. (Both films were deposited by applying 5 kw DC power to the titanium target, 1.5 kw RF power to the coil and providing a flow of argon to achieve 30 mT pressure).

As shown in Fig. 7, the film as represented by the data 300, which was deposited onto an externally biased substrate, exhibited crystallographic orientations in which a data peak corresponding to the crystallographic orientation of (002) appeared to be substantially absent. Instead, this film appeared to have two primary crystallographic orientations, (010) and (011). In contrast, the film as represented by the data 302 of Fig. 7 which was deposited onto a self biased substrate appeared to have substantially the same crystallographic orientation as the film deposited in a non-RFI chamber as indicated in Fig. 6, that is, a crystallographic orientation which is primarily in the (002) orientation. As set forth above, it is believed that such a crystallographic orientation in the titanium film can improve the quality of a subsequently deposited overlying aluminum film.

In a similar manner, it is believed that the crystallographic properties of a titanium nitride film deposited on a substrate which has not been externally biased during an RFI high density plasma deposition in accordance with the present invention, can be improved. Fig. 8 depicts data representing the crystallographic orientation of a titanium nitride film deposited in a convention physical vapor deposition chamber which does not utilize a coil to inductively couple RF energy into the plasma to ionize the deposition material from the target. As shown in Fig. 8, x-ray diffraction of the film produced in this manner indicates that the titanium nitride film has a primary orientation in the (111) crystallographic orientation. Here too, it is believed that such a crystallographic orientation in the titanium nitride film promotes good qualities in an aluminum film subsequently deposited over the titanium nitride. For example, it is generally believed that a (111) orientation in the titanium nitride film will influence a subsequently deposited overlying film of aluminum to similarly have a (111) orientation. Such an aluminum film may have improved electromigration properties.

By comparison, Fig. 9 depicts data representing the crystallographic orientations of two titanium nitride films, both deposited in an RFI high density plasma deposition chamber. However, one titanium nitride film as represented by the data line 400, was deposited on a substrate which was externally biased via a clamp ring applied to the substrate to a voltage of approximately -30 volts at a power of 90 watts. The other titanium nitride film as represented by the data line 402, was deposited with no external bias to the substrate. Instead, the substrate was clamped by a clamp ring and supported by a pedestal at floating potential, thereby permitting a self generated DC bias which was measured to be approximately -6 volts. (Both films were deposited by applying 5 kw DC power to the titanium target, 1.5 kw RF power to the coil and a flow of argon and nitrogen (for nitridization of the titanium) to achieve 30 mT pressure).

As shown in Fig. 9, the film as represented by the data 400, which was deposited onto an externally biased substrate, exhibited crystallographic orientations in which a data peak corresponding to the crystallographic orientation of (111) appeared to be substantially absent. Instead, this film appeared to lack predominant crystallographic orientations. In contrast, the film as represented by the data 402 of Fig. 9 which was deposited onto a self biasing substrate appeared to include a crystallographic orientation which is the same as that of the film deposited in a non-RFI chamber as depicted in Fig. 8, that is, a crystallographic orientation which dominates in the (111) orientation. As set forth above, it is believed that such a crystallographic orientation in the titanium nitride film can improve the quality of a subsequently deposited overlying aluminum film. Furthermore, the titanium nitride film as represented by the data 402 appeared to have another and even more dominating crystallographic orientation in the (200) orientation. Such an orientation is believed to improve (that is lower) the resistivity of the titanium nitride film and also enhance its barrier property to aluminum diffusion.

Thus, it is seen that by eliminating external biasing of the substrate, the resultant deposition films can be improved during RFI high density plasma depositions. The films can retain desirable characteristics of those films deposited in non-RFI plasma ionized depositions and yet at the same time substantially retain the improved step coverage over high aspect ratio vias and channels which was previously obtained by biasing the substrate in RFI high density plasma depositions. It is believed that bombardment of the film by high energy deposition ions may adversely affect the resultant film. In accordance with the present invention, the energy level of the bombarding ions is substantially reduced by permitting the substrate to self-generate a bias rather than externally biasing the substrate to a more negative voltage level than that which the substrate would achieve with self biasing. It is believed that this reduced ion energy level reduces adverse effects on the film such that the resultant film more closely resembles films deposited in non-RFI sputtering processes. In addition, the temperature rise of the substrate during the ion bombardment is ameliorated. However, notwithstanding the reduced bias level of the substrate, satisfactory step coverage may be achieved by utilizing the voltage drop across the plasma sheath adjacent to the substrate to redirect the ionized deposition materials in a direction more perpendicular to the substrate.

The deposition system 100 is preferably installed in a PVD (physical vapor deposition) system as described in greater detail in copending application Serial No. 08/647,182, entitled Recessed Coil for Generating a Plasma, filed May 9, 1996 (Attorney Docket # 1186/PVD/DV) and application Serial No. 08/644,096, entitled Coils for Generating a Plasma and for Sputtering, filed May 10, 1996 (Attorney Docket # 1390/PVD/DV), both of which are assigned to the assignee of the present application, and are both incorporated herein by reference in their entireties.

Each of the embodiments discussed above utilized a single coil in the plasma chamber. It should be recognized that the present invention is applicable to plasma chambers having more than one RF powered coil. For example, the present invention may be applied to multiple coil chambers for launching helicon waves of the type described in copending application serial No.08/559,345.

The appropriate RF generators and matching circuits are components well known to those skilled in the art. For example, an RF generator such as the ENI Genesis series which has the capability to "frequency hunt" for the best frequency match with the matching circuit and antenna is suitable. The frequency of the generator for generating the RF power to the coil 104 is preferably 2 MHz but it is anticipated that the range can vary from, for example, 1 MHz to 100 MHz. An RF power setting of 1.5 kW is preferred but a range of.5-6 kW is satisfactory. In addition, a DC power setting for biasing the target of 5kW is preferred but a range of 1-8 kW is satisfactory.

A variety of precursor gases may be utilized to generate the plasma including Ar, H₂ or reactive gases such as NF₃, CF₄ and many others. Various precursor gas pressures are suitable including pressures of 0.1 - 50 mTorr. For ionized PVD, a pressure between 10 and 100 mTorr is preferred for best ionization of sputtered material.

It will, of course, be understood that modifications of the present invention, in its various aspects, will be apparent to those skilled in the art, some being apparent only after study others being matters of routine mechanical and electronic design. Other embodiments are also possible, their specific designs depending upon the particular application. As such, the scope of the invention should not be limited by the particular embodiments herein described but should be defined only by the appended claims and equivalents thereof.

## Claims

1. A method of depositing material onto a substrate having an upper face, comprising:
energizing a plasma with RF energy;
sputtering atoms from a target;
ionizing at least greater than 1% of the sputtered atoms; and
depositing the ionized atoms onto the full upper face of an electrically floating substrate.

2. The method of claim 1 further comprising permitting the substrate to self-generate its potential.

3. The method of claim 1 wherein the resultant material deposited on the substrate is titanium having a crystallographic orientation which is predominantly (002).

4. The method of claim 1 wherein the resultant material deposited on the substrate is titanium nitride having crystallographic orientations which are predominantly (200) and (111).

5. The method of claim 1 wherein the plasma is energized with RF energy from a coil.

6. A method of depositing material onto a substrate comprising:
energizing a plasma with RF energy;
sputtering atoms from a target;
ionizing more than 1% of the sputtered atoms;
permitting the substrate to self-generate its potential; and
depositing the ionized atoms onto the substrate.

7. The method of claim 1 wherein a pedestal supporting the substrate is at a free-floating potential.

8. A method of depositing material onto a substrate comprising:
energizing a plasma with RF energy;
sputtering titanium atoms from a target;
ionizing 1% of the sputtered titanium atoms; and
depositing the ionized atoms onto an electrically floating substrate.

9. An apparatus for depositing sputtered material onto a substrate having an upper face and an underside, comprising:
a sputtering chamber for containing a plasma and having a target for sputtering material from the target;
an RF coil positioned to energize the plasma with RF energy to ionize at least greater than 1% of the sputtered material; and
a member for supporting a substrate, said member being at a free floating potential.

10. The apparatus of claim 9 wherein the pedestal engages only the underside of the substrate wherein the entire upper face of the substrate is deposited with ionized sputtered material.

11. The apparatus of claim 10 wherein the member has an upper surface and a plurality of dimples to support the substrate a predetermined distance above the upper surface of the member.

12. The apparatus of claim 9 wherein the target is made of titanium.

13. An apparatus for depositing titanium onto a substrate, comprising:
a sputtering chamber for containing a plasma, a titanium target and means for sputtering titanium from the target;
RF coil means for energizing the plasma with RF energy to ionize the sputtered titanium atoms; and
means for depositing the ionized titanium onto the substrate to form a titanium film having a crystallographic orientation which is predominantly (002).

14. An apparatus for depositing titanium nitride onto a substrate, comprising:
a sputtering chamber containing a plasma;
means for providing a source of titanium nitride within the chamber;
RF coil means for energizing the plasma with RF energy to ionize the titanium nitride; and
means for depositing the ionized titanium nitride onto the substrate to form a titanium nitride film having crystallographic orientations which are predominantly (200) and (111).

15. A method of depositing material onto a substrate having an upper face, comprising:
energizing a plasma with RF energy;
sputtering atoms from a target;
ionizing at least greater than 1% of the sputtered atoms; and
depositing the ionized atoms onto the full upper face of the substrate supported by a grounded member.

16. The method of claim 15 wherein the resultant material deposited on the substrate is titanium having a crystallographic orientation which is predominantly (002).

17. The method of claim 15 wherein the resultant material deposited on the substrate is titanium nitride having crystallographic orientations which are predominantly (200) and (111).

18. The method of claim 15 wherein the plasma is energized with RF energy from a coil.

19. A method of depositing material onto a substrate comprising:
energizing a plasma with RF energy;
sputtering titanium atoms from a target;
ionizing 1% of the sputtered titanium atoms; and
depositing the ionized atoms onto a substrate supported by a grounded member.

20. An apparatus for depositing sputtered material onto a substrate having an upper face and an underside, comprising:
a sputtering chamber for containing a plasma and having a target for sputtering material from the target;
an RF coil positioned to energize the plasma with RF energy to ionize at least greater than 1% of the sputtered material; and
a member for supporting a substrate, said member being grounded.

21. The apparatus of claim 20 wherein the pedestal engages only the underside of the substrate wherein the entire upper face of the substrate is deposited with ionized sputtered material.

22. The apparatus of claim 21 wherein the member has an upper surface and a plurality of dimples to support the substrate a predetermined distance above the upper surface of the member.

23. The apparatus of claim 20 wherein the target is made of titanium.
